# EUROPÄISCHE PATENTSCHRIFT

(11) **EP 0 710 064 B1**
(45) Veröffentlichungstag und Bekanntmachung des Hinweises auf die Patenterteilung: **28.10.1998**
(21) Anmeldenummer: 95114164.7
(22) Anmeldetag: 09.09.1995
(51) Int. Cl.: H05K 7/14, H01R 9/26

(54) **Feldbusanschlussmodul**
Field bus connection module
Module de connexion de bus de secteur

(30) Priorität: 31.10.1994 DE 4438805
(43) Veröffentlichungstag der Anmeldung: 01.05.1996
(73) Patentinhaber: Weidmüller Interface GmbH & Co., D-32760 Detmold (DE)
(72) Erfinder: Dux, Dietmar, D-32758 Detmold (DE); Hanning, Walter, D-32758 Detmold (DE); Fiene, Uwe, D-32839 Steinheim (DE); Schnatwinkel, Michael, D-32051 Herford (DE); Steinmeier, Rudolf, D-32760 Detmold (DE); Wilmes, Manfred, D-32760 Detmold (DE); Hamann, Christian, D-37603 Holzminden (DE); Beins, Eckhard, D-32758 Detmold (DE); Zebermann, Christoph, Dr., D-37688 Beverungen (DE); Glathe, Hans-Georg, D-32758 Detmold (DE); Herms, Martin, D-32657 Lemgo (DE); Liesenjohann, Matthiass, D-32791 Lage (DE); Steinkämper, Stefan, D-32760 Detmold (DE); Schuster, Bernhard, D-32758 Detmold (DE); Eggert, Gerhard, D-32760 Detmold (DE)
(74) Vertreter: Stracke, Alexander, Dipl.-Ing.

(56) Entgegenhaltungen:
- DE-A- 3 924 161
- DE-A- 4 303 717
- DE-C- 4 410 171
- DE-U- 8 411 255
- FR-A- 2 486 757

## Beschreibung

Die Erfindung betrifft ein Feldbusanschlußmodul zur Kopplung eines lokalen Busleiters mit einem zugeordneten Feldbussystem gemäß Oberbegriff des Anspruchs 1.

Bei dem Aufbau von Steuerungssystemen für z.B. Maschinen bzw. Anlagen werden zur Verdrahtung zunehmend Steuerungssysteme eingesetzt, die auf Basis eines viele lokale Stationen der Maschinen- bzw. Anlage verbindenden Feldbussystems arbeiten. Hierbei werden lokale Initiatoren, Aktoren, Feldgeräte oder dergleichen bis zu ebenfalls lokal in der Nähe dieser Einrichtungen angeordneten Schaltkästen mittels konventioneller Verdrahtungstechnik verbunden, wobei innerhalb eines derartigen lokalen Schaltkastens eine Umsetzung der Signale von und zu den Initiatoren, Aktoren, Feldgeräten oder dergleichen auf ein internes Bussystem erfolgt und dieses interne Bussystem über einen Netzknoten mit einem übergeordneten Feldbussystem verbunden ist. Die in dem lokal angeordneten Schaltkasten zusammenlaufenden Kabel zu den Initiatoren, Aktoren, Feldgeräten oder dergleichen werden dabei auf Anschlußblocks geführt, die zum einen die physikalische Anbindung der Kabel an die benötigten elektrischen Potentiale erlauben, zum anderen eine Anpassung der an den Anschlußblocks anliegenden Signale auf ein lokales Busleitersystem erlauben.

Derartige Busleitersysteme sind in der Regel zur Verbindung einer Anzahl an einer gemeinsamen Tragschiene angeordneten Anschlußblocks vorgesehen, wobei jeder der einzelnen Anschlußblocks über Elektronikmodule mit dem lokalen Busleitersystem verbindbar ist. Das oder die lokalen Busleitersysteme in einem derartig maschinennah angeordneten Schaltkasten werden für den Anschluß an das übergeordnete Feldbussystem auf ein oder mehrere Feldbusanschlußmodule zusammengeführt, die die Signalumsetzung des lokalen Busleitersystems auf die Signalkonventionen des Feldbussystems übemehmen. Hierbei werden üblicherweise herstellerspezifische lokale Busleitersysteme auf ein genormtes, aus einer Anzahl verschiedener möglicher Feldbussysteme angepaßt. Von dem jeweils busleiterspezifischen Feldbusanschlußmodul, das üblicherweise in Form eines Netzwerkknotens mit einem beispielsweise im ring- oder busförmig angeordneten Feldbuskabel verbindbar ist, werden die Signale an die übergeordnete Steuerungseinheit, beispielsweise eine speicherprogrammierbare Steuerung (SPS) übertragen. Anders herum werden von der übergeordneten Steuerungseinheit auch Signale für die Initiatoren, Aktoren, Feldgeräte oder dergleichen vor Ort an das Feldbusanschlußmodul gesendet und dort auf das Signalniveau des intemen Busleiters und dann im Elektronikmodul auf das Signalniveau des Initiators, Aktors oder Feldgerätes umgesetzt.

Handelsübliche Feldbusanschlußmodule der gattungsgemäßen Art bestehen üblicherweise aus einem in ein geschlossenens Gehäuse eingesetzten Elektronikteil, das üblicherweise aus einer oder mehreren Platinen besteht und zum einen Verbindungselemente, beispielsweise Steckeinrichtungen oder dergleichen zum Verbinden zwischen Feldbus und Feldbusanschlußmodul aufweist. Üblicherweise im Inneren des Feldbusanschlußmoduls ist die Verbindung zu dem lokalen Busleitersystem hergestellt, das mittels einer Busleiterplatine oder über zwischengeschaltete Steckeinrichtungen, beispielsweise Flachbandkabel mit Platinensteckern, an die Anschlußblocks geführt wird. Derartige Feldbusanschlußmodule sind für bestimmte Feldbussysteme ausgelegt und stellen für den Anwender ein in sich geschlossenes System dar, das als Einheit an die Anschlußblocks der Tragschiene angereiht wird. Die üblicherweise recht groß bauenden Feldbusanschlußmodule der gattungsgemäßen Art müssen zu Wartungszwecken von ihnen zugeordneten Anschlußblocks aus dem Netzwerk des Feldbussystems mechanisch und elektrisch ausgekoppelt werden, um eine Trennung des dem Netzwerkknoten zugeordneten Bereich der Anschlußblocks zu erreichen. Hierdurch wird die Funktion des gesamten Feldbussystems und damit eine Vielzahl von Funktionen an der Maschine bzw. Anlage außer Kraft gesetzt. Handelsübliche Feldbusanschlußmodule müssen deshalb für Wartungszwecke mittels Brückungseinrichtungen, beispielsweise Verbindungskabeln oder gesonderte Wartungseinheiten, für die Wartungszeit überbrückt werden, wofür ein zumindest kurzzeitiges Außerbetriebnehmen der Maschine bzw. Anlage erforderlich ist. Auch ist durch den innerhalb eines geschlossenen Gehäuses typischerweise unzugänglich angeordneten Elektronikbereich eine Wartung nur unter einem kompletten mechanischen Ausbau des Feldbusanschlußmodules möglich, ein Austausch von Einzelkomponenten oder Bestandteilen des Feldbusanschlußmodules ist daher in der Regel vor Ort nicht möglich.

Aus der DE-PS 30 26 247 ist ein Bausystem auf Basis eines Gehäuses bekannt, wobei die Aufgabe darin besteht, das zur Aufnahme einer Mehrzahl von elektronischen Bauelementen bestimmte Gehäuse so auszugestalten, daß bei einfacher Auswechselbarkeit der Schaltungsplatte und einer einfacheren Variationsmöglichkeit der elektrischen Anschlüsse eine Beschränkung der Bauelementgröße auf die Bautiefe der anreihbaren Bauteile vermieden ist und darüber hinaus auch keine Anschlußklemmen mit abgewinkelten Anschlüssen verwendet zu werden brauchen. Diese Aufgabe wird durch ein hintereinander anreihbares, eine Mehrzahl von elektronischen Bauelementen aufnehmendes Gehäuse gelöst, das mit an einer Rückwand angeformten, jeweils aus mehreren treppenförmig von außen nach innen versetzt angeordneten Seitenwandabschnitten bestehenden Seitenwänden und einer Vorderwand besteht, in die mindestens eine die elektronischen Bauelemente tragende, in das Gehäuse einsetzbare Schaltungsplatte einsetzbar ist, wobei die auf der Schaltungsplatte an den Rändem angeordneten elektrischen Anschlußelemente aus den zwischen den Seitenwandabschnitten befindlichen Öffnungen des Gehäuses herausragen. Die Vorderwand ist dabei lösbar an den Seitenwandabschnitten befestigt, wobei jeder der Seitenwandabschnitte im Bereich der zur Vorderwand hin offenen Öffnungen mit jeweils einer nach innen gerichteten Nut parallel zur Anreihrichtung versehen ist zum Einschieben der mit handelsüblichen mit gerade durchgehenden Anschlußstiften versehenen Anschlußelementen bestückbaren Schaltungsplatten, wobei die Länge der Schaltungsplatten jeweils dem Abstand zweier sich gegenüberliegenden Nuten entspricht. Dieses grundsätzlich modular aufgebaute Gehäuse bietet damit zwar Aufnahmen für die Schaltungsplatten und die darauf angeordneten Anschlußelemente, doch sind neben dem hohen Bauaufwand und der aufwendigen Herstellung des Gehäuses nur feste Baulängen der Schaltungsplatten und damit der Anschlußelemente möglich. Eine Variation in der Reihung der Anschlußelemente ist nur mit einer entsprechend hohen Zahl von Gehäusebauformen zu lösen.

Aus der DE-A-4 303 717 ist ein Ein-/Ausgabemodul bekannt, der aus einem Anschlußblock und einem Elektronikblock besteht, wobei der Anschlußblock einerseits Versorgungsklemmen und andererseits Eingangs- und Ausgangsklemmen aufweist. Der Aufbau erfolgt modular aus einzelnen Anschlußscheiben. Das Anschließen von Busleitern geschieht dort in der Weise, daß im Fall eines Lösens der Verbindung die Verbindung zu nachfolgenden Anlagebereichen unterbrochen ist.

Aus dem DE-U-8 411 255 ist ein Bauelementen-Stecker für anreihbare elektrische Basisklemmen bekannt, in dem bestückte Leiterplatten angeordnet werden können. Der mehrpolige Stecker beinhaltet eine Trennstelle. Bei geöffneter Trennstelle sind sämtliche nachfolgenden Anlagebereiche stromlos.

Aufgabe der vorliegenden Erfindung ist es daher, ein modular aufgebautes und einfach an verschiedene Feldbussysteme und daraus resultierende verschiedene benötigte Bauräume für die Elektronik zur Anpassung der Signale anpaßbares Feldbusanschlußmodul bereitzustellen, das von seinem Aufbau her zu den ebenfalls modular aufgebauten, dem Feldbusanschluß zugeordneten Steuerungssystemen paßt und daß bei einer Wartung eines an einer Tragschiene angeordneten Steuerungssystems im stillgelegten Zustand ohne Beeinträchtigung der restlichen, am Feldbus angeordneten Funktionselemente erfolgen kann und eine kompakte, zu den Platzverhältnissen innerhalb eines Schaltkastens passende Bauform aufweist.

Die Lösung der erfindungsgemäßen Aufgabe ergibt sich aus den kennzeichnenden Merkmalen des Anspruchs 1.

Für das erfindungsgemäße Feldbusanschlußmodul zur Kopplung eines lokalen Busleiters mit einem zugeordneten Feldbussystem wird ein Gehäuse an der Unterseite und an den Seitenwänden aus einer Anzahl aneinanderreihbarer Anschlußscheiben gebildet, wobei diese Reihung von einzelnen Anschlußscheiben sowohl eine Veränderung an unterschiedliche Baumaße der darin unterzubringenden Elektronik als auch eine Anpassung an ebenfalls modular ausgeführte Anschlußblocks in einem anpaßbaren Steuerungssystem erlaubt. Das Feldbusanschlußmodul besteht aus einer Anzahl von funktionsverschiedenen Anschlußscheiben, die aus mindestens einer Einspeisescheibe, mindestens einem Distanzelement zur Bildung eines Bauraumes für die Aufnahme der Elektronik und mindestens einer Schutzleiterscheibe bestehen. In einer bevorzugten Ausführungsform betsteht der Feldbusanschlußmodul aus Anschlußscheiben in der Reihenfolge: mindestens eine Einspeisescheibe, daran anschließend mindestens ein Distanzelement und als Abschluß mindestens eine Schutzleiterscheibe.

Hierbei werden die Funktionen einer Einspeisung von elektrischen Potentialen in mindestens einer Einspeisescheibe zusammengefaßt, der bevorzugt in Richtung der gemeinsamen Tragschiene am anderen Ende des Feldbusanschlußmoduls eine Schutzleiterscheibe gegenübersteht, die die Schirmung des Elektronikbereichs des Feldbusanschlußmodules gewährleistet. Zwischen Einspeisescheibe und Schutzleiterscheibe ist ein der Größe des benötigten Bauraumes für die Umsetzungselektronik entsprechendes Distanzelement angeordnet, das nur gehäuseseitige Tragund Haltefunktionen zu erfüllen hat.

An der Oberseite wird das derart gebildete Gehäuse des Feldbusanschlußmodules bevorzugt durch einen Deckel übergriffen und geschlossen, an dem eine Funktionsleiterplatte lösbar befestigbar ist. Die Funktionsleiterplatte umfaßt alle zur Verbindung von Feldbus und lokalem Busleiter benötigten Funktionen sowie mechanischen und elektrischen Schnittstellen. Eine Entfernung des Deckels mit der daran befestigten feldbusseitigen Funktionsleiterplatte oder dieser allein unterbricht zwangsläufig eine lösbare Verbindung zwischen dem Feldbus und einer busleiterseitigen Funktionsleiterplatte, mit der der lokale Busleiter verbunden ist, wobei die Verbindungen zum Feldbussystem weiterhin funktionstüchtig bleiben und der Feldbus mit seiner Funktionsleiterplatte verbunden ist. Dadurch wird, obwohl der Deckel und die Funktionsleiterplatte vom Gehäuse entfernt sind, die Funktion des an die Funktionsleiterplatte angebundenen Feldbussystems nicht beeinträchtigt. Deckel und/oder Funktionsleiterplatte können im an den Feldbus abgeschalteten Zustand verbleiben, während die an der Tragschiene angeordneten Anschlußblocks und das Unterteil des Gehäuses des Feldbusanschlußmoduls z.B. gewartet oder repariert werden können. Die Funktionsweise der Gesamtanlage oder der Gesamtmaschine ist durch die weiterhin aufrecht erhaltene Funktionalität des Feldbusses gewährleistet, bis auf den Bereich, der direkt dem Feldbusanschlußmodul zugeordnet ist. Weitere vorteilhafte Ausführungsformen des erfindungsgemäßen Feldbusanschlußmodules enthalten die Unteransprüche.

Der benötigte Bauraum für die Aufnahme der Funktionsleiterplatten und sonstiger benötigter Funktionselemente des Feldbusanschlußmodules wird derart aufgebaut, daß zwischen Einspeisescheibe und Schutzleiterscheibe, die an die Tragschiene verrastbar sind, ein ausreichend großes Distanzelement, vorzugsweise aus einer ausreichend großen Anzahl von Distanzscheiben reihbar angeordnet werden, das eine für die Aufnahme auch unterschiedlich langer Funktionsleiterplatten ausreichende Baulänge des Feldbusanschlußmodules erzielbar macht. Diese Distanzscheiben weisen einen Anschlagfuß zur mechanischen Positionierung der Distanzscheiben an der Tragschiene auf, ohne jedoch eine Rastfunktion zu besitzen. In einer weiteren Ausführungsform können zwischen diesen einzelnen Distanzscheiben auch Einspeisescheiben und Schlutzleiterscheiben angeordnet sein. In einer vorteilhaften Ausführungsform wird der Deckel des Gehäuses des Feldbusanschlußmodules um einen Drehpunkt schwenkbar ausgeführt und losbar sowie verrastbar am Gehäuse befestigt.

Die allein oder mit dem Deckelgehäuse entfernbare Funktionsleiterplatte weist mindestens einen Steckverbinder, vorzugsweise als genormten Feldbusstecker und mindestens einen Verbinder zur Direktverdrahtung der Feldbuskabel mit dem Feldbusanschlußmodul auf. Dabei sind Steckverbinder und Verbinder zur Direktverdrahtung sowohl auf der Ausgangsseite als auch auf der Eingangsseite des Feldbusanschlußmodules jeweils miteinander elektrisch verbunden. Durch Verbindung der Eingangsseite und der Ausgangsseite der Steckverbinder beziehungsweise der Verbinder zur Direktverdrahtung wird erreicht, daß auch bei abgenommenem Gehäuse und Funktionsleiterplatte weiterhin das Feldbussystem durchgängig verbunden ist, wobei nur die als in elektrischem Sinne T-stückförmige Verbindung zum Busleiter unterbrochen wird.

Der Deckel des Gehäuses des Feldbusanschlußmodules ist auch ohne Funktionsleiterplatte entfernbar, wodurch die Funktionsleiterplatte auch bei entferntem Deckel weiterhin die Verbindung zwischem dem lokalen Busleiter und dem Feldbus herstellt.

In einer besonders vorteilhaften Ausführungsform wird die Ankopplung von Feldbus und lokalem Bus über mindestens zwei, funktionell getrennte und miteinander lösbar elektrisch und verbindbare Funktionsleiterplatten hergestellt. Hierdurch kann die für die elektrische Kopplung erforderliche Elektronik auf einer Funktionsleiterplatte, der feldbusseitig angeordneten Funktionsleiterplatte, zusammengefaßt werden. Die zur Signalumsetzung erforderliche Elektronik kann dann auf einer oder mehreren busleiterseitig angeordneten Funktionsleiterplatten zusammengefaßt sein. Beim Entfernen des Gehäusedeckels des Feldbusanschlußmodules wird dabei eine lösbare Verbindung der feldbusseitigen und busleiterseitigen Funktionsleiterplatten untereinander zwangsläufig aufgehoben, wodurch ebenfalls zwangsläufig der lokale Busleiter vom Feldbusteil des Feldbusanschlußmodules abgekoppelt ist.

In einer bevorzugten Ausführungsform werden die Funktionsleiterplatten mit ihrer Plattenebene parallel zum Gehäuseboden des Feldbusanschlußmodules einsteckbar gestaltet, so daß die Bauhöhe des Feldbusanschlußmodules niedrig ausfallen kann. Auch ist eine Steckverbindung derartig übereinandergestaptelter, voneinander beabstandeter Funktionsleiterplatten einfach kabellos durch z.B. einen Platinenstecker herstellbar.

Vorzugsweise wird die busleiterseitige Funktionsleiterplatte fest in das Gehäuse des Feldbusanschlußmodules eingesteckt und zur Potentialverteilung für das Bussystem benötigter elektrischer Potentiale elektrisch mit der Einspeisescheibe des Feldbusanschlußmodules, vorzugsweise durch eine durch das Einstecken zwangsläufig betätigte Kontaktverbindung, verbunden.

Der erfindungsgemäße Feldbusanschlußmodul bietet weiterhin in einer bevorzugten Ausführungsform die Möglichkeit zum Abgriff elektrischer Potentiale für die dem Feldbusmodul zugeordneten Anschlußblocks, in dem die an der Einspeisescheibe anliegende Spannungsversorgung mittels einer Querverteilung vervielfacht wird, wobei vorzugsweise die Querverteilung durch einsteckbare Anschlußelemente erfolgt, die in mindestens einer Vorrichtung zur Aufnahme von Verteilerleisten angeordnet sind und über eine durch das Einstecken bzw. durch das Reihen zur Verteilerleiste zwangsläufig aufgebaute Querverteilung miteinander verbunden sind.

Eine Einspeisescheibe des erfindungsgemäßen Feldbusanschlußmodules weist mindestens zwei Vorrichtungen zur Aufnahme von Verteilerleisten und eine mechanische Rastfußfunktion auf.

Ebenfalls ist die Schutzleiterscheibe mit einer mechanischen Rastfußfunktion versehen und stellt darüber hinaus einen elektrischen Kontakt zur Tragschiene her, die zur Schirmung des Bussystems und der Elektronik des Feldbusanschlußmodules nutzbar ist.

Eine bevorzugte Ausführungsform des erfindungsgemäßen Feldbusanschlußmodules zeigt die Zeichnung.

Es zeigen:
- Fig. 1: eine perspektivische Ansicht des montierten Feldbusanschlußmodules mit vertikal abgehobenen, darüber angeordneten Gehäusedeckel und im Feldbusanschlußmodul verrasteter feldbusseitiger Funktionsleiterplatte,
- Fig. 2: eine Seitenansicht der Einspeiseklemme des erfindungsgemäßen Feldbusanschlußmodules,
- Fig. 3: eine Seitenansicht der Schutzleiterscheibe des erfindungsgemäßen Feldbusanschlußmodules,
- Fig. 4: eine Distanzscheibe in Seitenansicht.

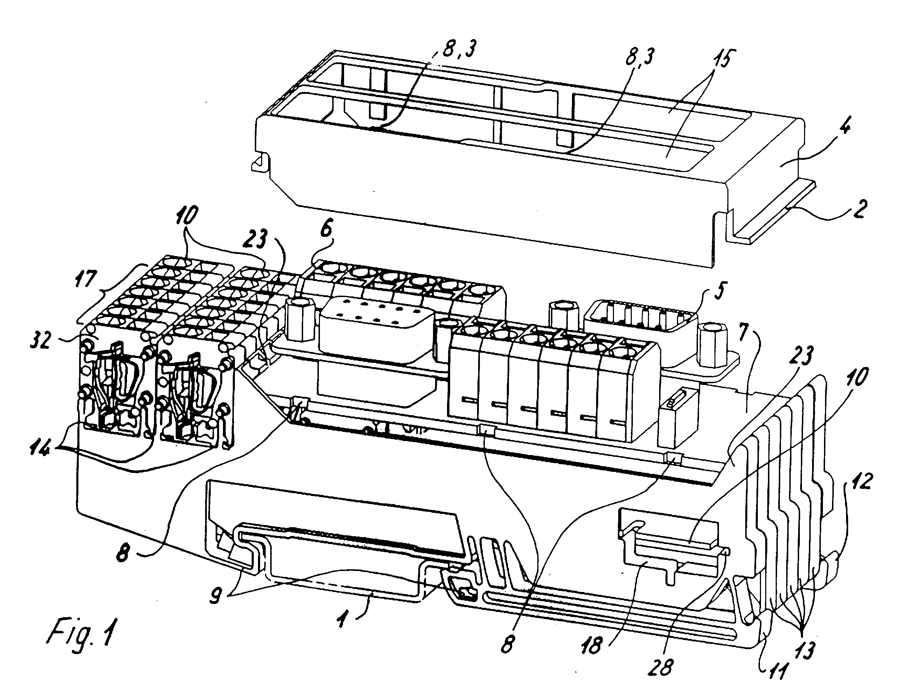

In Figur 1 ist eine vorteilhafte Ausführungsform des erfindungsgemäßen Feldbusanschlußmodules dargestellt, die aus einer Aneinanderreihung von einer Einspeisescheibe 12, einem Distanzelement 13 aus einer Anzahl von Distanzscheiben sowie einer Schutzleiterscheibe 11 besteht, in die im unteren Gehäusebereich eine busleiterseitige Funktionsleiterplatte 10 eingesteckt ist und im oberen Bereich des Gehäuses einen z.B. schwenkbaren Deckel aufnimmt, mit dem eine feldbusseitige Funktionsleiterplatte 7 verrastet ist. Das Gehäuse des Feldbusanschlußmodules wird durch einen Deckel 4 geschlossen, der in der Figur 1 in vertikaler Verlängerung oberhalb des Feldbusanschlußmodules dargestellt ist. Das Gehäuse des Feldbusanschlußmodules ist auf einer Tragschiene 1 mittels Rastfüßen 9 in der Schutzleiterscheibe 11 und der Einspeisescheibe 12 klemmbar befestigt, wodurch die Reihung der Anschlußscheiben 11 bis 13 zusätzlich stabilisiert ist.

Seitlich der Tragschiene 1 ist im Bereich der Versorgungsanschlüsse eines nachgeordneten, nicht dargestellten Anschlußblocks eine Anzahl von Verteilerleisten 32 dargestellt, die sich aus einzelnen Anschlußelementen 17 in einer Reihung zusammensetzen und gehäuseseitig an dem Feldbusanschlußmodul durch Rast- und Führungsleisten 14 für die Verteilerleisten 32 angesteckt sind. Die Anschlußelemente 17 sind durch in Richtung der Erstreckung der Verteilerleisten 32 angeordnete, querverbindende Leiterelemente miteinander elektrisch leitend verbunden, wobei die elektrisch leitende Verbindung bis zu Anschlußelementen 16 verläuft, die auf der Einspeisescheibe 12 in den Rast- und Führungsleisten 14 eingesteckt sind. In diesen Anschlußelementen 16 wird eine Versorgungsspannung von einer nicht dargestellten, externen Spannungsquelle mittels Kabelverbindung angeschlossen und somit stehen über die querverteilenden Anschlußelemente 17 eine der Anzahl der Anschlußscheiben 11 - 13 entsprechende Anzahl von Einsteckmöglichkeiten für die Spannungsversorgung nachgeordneter Anschlußblocks an der Tragschiene 1 zur Verfügung.

Die feldbusseitige Funktionsleiterplatte 7 trägt auf ihrer dem Deckel 4 zugeordneten Oberseite Verbindungselemente 5, 6 zum Anschluß der den Deckel 4 an den Ausnehmungen 15 durchtretenden Feldbusanschlußkabel. Diese Verbindungselemente können als genormte Feldbusstecker 5 ausgeführt sein, es ist auch besonders vorteilhaft, zusätzlich zu den genormten Feldbussteckern 5 Direktverdrahtungssockel 6 für die Feldbuskabel auf der feldbusseitigen Funktionsleiterplatte 7 vorzusehen. Dies kann vor allem bei geringem Bauraum von Vorteil sein, da die genormten Feldbusstecker 5 eine große Bauhöhe für die entsprechend kabelseitig angeordneten Gegenstücke erfordern.

Die Verschaltung der Verbindungselemente 5 bzw. 6 erfolgt dabei dergestalt, daß jeweils der Eingangs- bzw. der Ausgangsseite des Feldbusanschlusses je ein Satz von genormten Feldbussteckern 5 bzw. Direktverdrahtungssockeln 6 zugeordnet sind, die jeweils eine elektrisch leitende Verbindung mit der jeweils anderen Eingangs- bzw. Ausgangsseite aufweisen. Hierdurch ist es möglich, daß auch bei abgenommener feldbusseitiger Funktionsleiterplatte 7 eine Verbindung zwischen der Eingangs- und der Ausgangsseite des Feldbusses am Feldbusanschlußmodul besteht, wodurch die Funktionsweise des Feldbusses durch ein Abnehmen der Funktionsleiterplatte 7 vom Feldbusanschlußmodul nicht gestört wird. Die Verbindung der Eingangs- und Ausgangsseite des Feldbusanschlusses erfolgt vorteilhafterweise mittels Verbindungen auf der feldbusseitigen Funktionsleiterplatte 7.

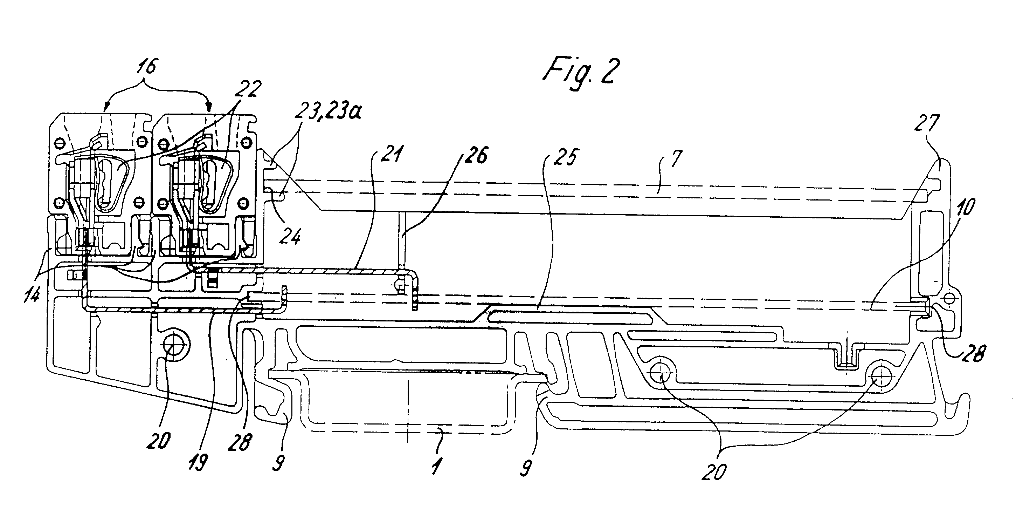

Die feldbusseitige Funktionsleiterplatte 7 wird, wie später noch in den Figuren 2 bis 4 näher dargestellt, um einen Drehpunkt 24 herum aus dem Gehäuseunterteil des Feldbusanschlußmoduls ausgeschwenkt.

Der Drehpunkt 24 liegt hierbei auf der Gehäuseseite, die den Verteilerleisten 32 mit den Anschlußelementen 17 zugeordnet ist. Auf der diesem Drehpunkt gegenüberliegenden Seite der Funktionsleiterplatte 7 wird die Funktionsleiterplatte 7 mit dem Deckel 4 über einen Rasthaken 27 an dem Gehäuseunterteil des Feldbusanschlußmodules festgelegt.

An der unteren, busleiterseitigen Platine 10 ist in einer Gehäuseausnehmung 18 mittels entsprechender Formgebung der Funktionsleiterplatte 10 vorgesehen, den in der Figur 1 nicht dargestellten Busleiter mittels einer steck- und lösbaren Verbindung an die Funktionsleiterplatte 10 anzukoppeln, wodurch sowohl ein mechanischer als auch ein elektrisch leitender Kontakt zwischen dem Busleiter und der busleiterseitigen Funktionsleiterplatte hergestellt wird. Die Ausnehmung 18 in dem Gehäuseunterteil weist hierzu entsprechende Führungseinrichtungen auf. Die busleiterseitige Funktionsleiterplatte 10 ist in zwei Einschiebenuten 28 in die Anschlußscheiben 11 - 13 eingeschoben, wobei das Einschieben nach Aneinanderreihung der Anschlußscheiben 11 - 13, aber vor einer Anreihung einer der beiden die Anreihung in Verlaufsrichtung der Tragschiene 1 begrenzenden Anschlußscheiben 11, 12 erfolgt. Beispielsweise wird die busleiterseitige Funktionsleiterplatte 10 in eine Aneinanderreihung von Einspeisescheibe 10 und einer Anzahl von Distanzscheiben 13 vorgenommen, bevor die Schutzleiterscheibe 11 endgültig angereiht wird.

Der Gehäusedeckel 4 weist einen Rastansatz 2 an seiner parallel zur Tragschiene 1 verlaufenden Stirnseite auf, der mit Rasthaken 27 an den Distanzscheiben 13 korrespondiert und eine einseitig klemmende Anordnung der Funktionsleiterplatte 7 und des Gehäusedeckels 4 ermöglicht. Auf der anderen Stimseite des Gehäusedeckels 4 ist in analoger Weise eine vom Gehäusedeckel 4 hintergriffene Einlegekonsole 23 vorgesehen, die mit dem Rastansatz 2 eine beidseitige Festlegung des Gehäusedeckels 4 erlaubt. Der Gehäusedeckel 4 wird zum Abnehmen ebenso wie die Funktionsleiterplatte 7 um einen gemeinsamen Drehpunkt 24 ausgeschwenkt und kann dann vollständig abgenommen werden.

Eine Verrastung von Gehäusedeckel 4 und feldbusseitiger Funktionsleiterplatte 7 erfolgt beispielsweise mittels Rasthaken 3 am Deckel, die in Verlängerung der zu den Seitenflächen des Gehäuses verlaufenden Außenwand des Deckels 4 angeordnet sind. Hierzu ist eine beidseitig dieser Seitenflächen angeordnete, nach unten gezogene Schürze vorgesehen, an der auf der Innenseite des Deckels Rasthaken 3 angeordnet sind, hinter der die Funktionsleiterplatte 7 verrastet.

In den Figuren 2 bis 4 sind die Anschlußscheiben dargestellt, die den unteren Bereich des Gehäuses des Feldbusanschlußmodules bilden. Gleiche Funktionselemente sind in diesen Zeichnungen mit gleichen Sachnummern bezeichnet und nur einmal erklärt.

In der Figur 2 ist eine Einspeisescheibe 12 dargestellt, die an einer Tragschiene 1 mittels Rastfüßen 9 angeordnet ist und an der durch Führung an Reihungszapfen bzw. -bohrungen 20 weitere Distanz- oder Schutzleiterscheiben 11, 13 angeordnet werden können. Auf der Versorgungsseite des Feldbusanschlußmodules sind Anschlußelemente 16 dargestellt, in die von oben in entsprechende Ausnehmungen Versorgungskabel einsteckbar und mittels Klemmelementen 22 befestigbar sind. Hier können ebenfalls beliebige andere, handelsübliche Befestigungssysteme für Kabel zum Einsatz kommen. Die Anschlußelemente 16 sind in einer Reihung in Rast- und Führungsleisten 14 an dem Gehäuse der Einspeisescheibe 12 angeordnet und mit diesen Rast- und Führungsleisten 14 verrastet. Senkrecht zur Zeichnungsebene sind diese Anschlußelemente 16 mit den benachbarten Anschlußelementen zu einer Verteilerleiste 32 aneinandergereiht, wobei hier nicht weiter dargestellte, elektrisch diese Anschlußelemente 16 querverbindende Einrichtungen vorgesehen sind.

An der Unterseite der Anschlußelemente 16 sind an dem einen Anschlußelement ein Kontaktierungssteg 21 und an dem anderen Anschlußelement ein KontaktierungsSteg 19 vorgesehen, die zu der busleiterseitigen Funktionsleiterplatte 10 führen und dort an entsprechenden Gegenkontakten festlegbar sind. Hierdurch wird die Versorgungsspannung, die an den Anschlußelementen 16 von einer externen, nicht dargestellten Spannungsversorgung zugeführt wird, an die busleiterseitige Funktionsleiterplatte 10 geführt und damit der Busleiter elektrisch angeschlossen. Die busleiterseitig angeordnete Funktionsleiterplatte 10 ist in Einschiebenuten 28 geführt und wird durch die Rückwand der Einspeiseklemme 12 umschlossen. An dieser Rückwand ist ein Haltesteg 26 angeordnet, der den Kontaktierungssteg 21 stabilisiert. Gestützt wird die busleiterseitig angeordnete Funktionsleiterplatte 10 durch eine Unterstützungsrippe 25, die mechanische Belastungen der Funktionsleiterplatte 10 abstützt. Oberhalb der busleiterseitig angeordneten Funktionsleiterplatte 10 ist die feldbusseitige Funktionsleiterplatte 7 derart angeordnet, daß sie auf einer unteren Einlegekonsole 23 und auf der gegenüberliegenden Seite unterhalb eines Rasthakens 27 gehäuseseitig aufliegt, wobei oberhalb der Einlegekonsole 23 ebenfalls eine etwas zurückversetzte Einlegekonsole 23a vorgesehen ist, die eine vertikale Herausnahme der Funktionsleiterplatte 7 ohne eine Drehung um einen Schwenkbezugspunkt 24 unmöglich macht. Zum Herausnehmen der Funktionsleiterplatte 7 wird diese um den Schwenkbezugspunkt 24 verschwenkt und dann seitlich unter der oberen Einlegekonsole 23a herausgezogen. Die feldbusseitige Funktionsleiterplatte 7 wird durch den Gehäusedeckel 4 festgelegt, der direkt auf der Oberseite der Funktionsleiterplatte 7 aufliegt und unter die obere Einlegekonsole 23a und unter den Rasthaken 27 einschwenkbar und festlegbar ist.

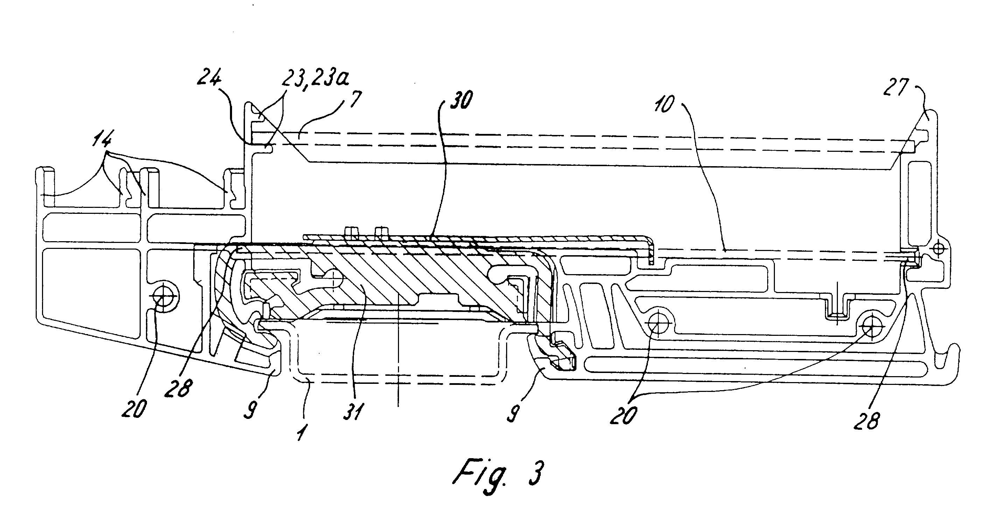

In der Figur 3 ist eine Schutzleiterscheibe 11 dargestellt, die einen prinzipiell gleichen Aufbau wie die vorstehend erläuterte Einspeisescheibe 12 aufweist. Funktionsunterschiedlich ist zum einen die zusätzlich zu der Verrastung mittels Rastfüßen 9 vorgesehene elektrische Verbindung der Schutzleiterscheibe 11 mit der Tragschiene 1, wobei diese aus einem an der Tragschiene zwangsläufig festlegbaren Kontaktblech 31 besteht, an dessen Oberseite innerhalb des Einbauraums für die Funktionsleiterplatten 7 und 10 ein Kontaktierungssteg 30 festgelegt ist, der an der busleiterseitigen Funktionsleiterplatte 10 elektrisch leitend festlegbar ist. Hierdurch wird die busleiterseitige Funktionsleiterplatte direkt mit seiner Abschirmung an die Tragschiene 1 angeschlossen.

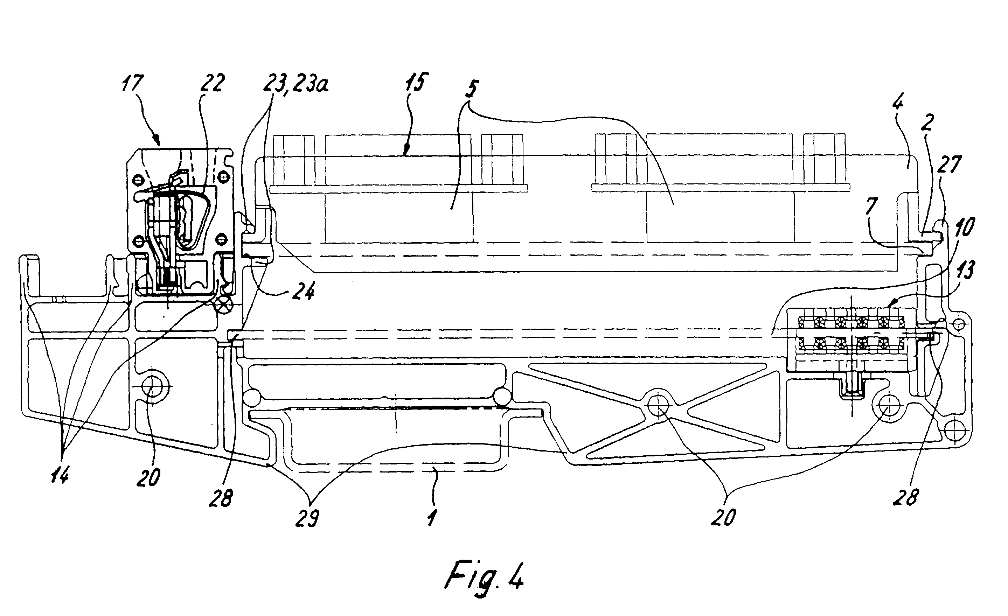

In der Figur 4 ist ein Distanzelement 13 aus einzelnen Distanzscheiben dargestellt, wobei in die Distanzscheiben der Gehäusedeckel 4 eingesetzt ist und die Funktionsleiterplatte 7 festlegt. Die Distanzscheiben weisen keine Rastfußfunktion zur Tragschiene 1 auf, sondern nur sogen. Anschlagfüße 29, die eine Positionierung der Distanzscheiben ermöglichen. An der feldbusseitigen Funktionsleiterplatte 7 sind die Feldbusstecker 5 bzw. Direktverdrahtungssockel 6 angeordnet, oberhalb derer die Ausnehmungen 15 an der Deckeloberseite vorgesehen sind. Ebenfalls erkennt man die Verrastung zwischen Deckel 4 und Funktionsleiterplatte 7 mit Hilfe des Rastelementes 3.

### Bezugszeichenliste

- 1: Tragschiene
- 2: Rastansatzdeckel
- 3: Rasthakendeckel
- 4: Deckel
- 5: Feldbusstecker
- 6: Direktverdrahtungssockel für Feldbuskabel
- 7: Feldbusseitige Funktionsleiterplatte
- 8: Rastvertiefungen feldbusseitige
Funktionsleiterplatte
- 9: Rastfüße
- 10: Busleiterseitige Funktionsleiterplatte
- 11: Schutzleiterscheibe
- 12: Einspeisescheibe
- 13: Distanzelement, vorzugsweise aus Distanzscheiben
- 14: Rast- und Führungsleisten für Verteilerleisten
- 15: Ausnehmungen an Deckeloberseite
- 16: Anschlußelemente für Einspeisescheibe
- 17: Anschlußelemente in Reihung zur Verteilerleiste
- 18: Gehäuseausnehmungen für Busleiter
- 19: Kontaktierungssteg
- 20: Reihungszapfen bzw. -bohrungen
- 21: Kontaktierungssteg
- 22: Klemmelement
- 23, 23a: Einlegekonsolen
- 24: Schwenkbezugspunkt
- 25: Unterstützungsrippe
- 26: Haltesteg
- 27: Rasthaken
- 28: Einschiebenut
- 29: Anschlagfuß
- 30: Kontaktierungssteg
- 31: Kontaktblech
- 32: Verteilerkasten

## Patentansprüche

1. Feldbusanschlußmodul zur Kopplung eines lokalen Busleiters mit einem zugeordneten Feldbussystem enthaltend
mindestens eine Funktionsleiterplatte (7) zur Anpassung der Signale eines lokalen Busleiters an das Feldbussystem,
Verbindungselemente (5, 6) zum Herstellen einer lösbaren elektrischen Verbindung zwischen Feldbus und Feldbusanschlußmodul,
eine Verbindung (10) des Feldbusanschlusmoduls zum lokalen Busleiter,
**dadurch gekennzeichnet, daß**
Unterseite und Seitenwände eines Gehäuses des Feldbusanschlußmoduls aus einer Anzahl aneinanderreihbarer Anschlußscheiben (11-13) gebildet sind,
die Anschlußscheiben (11-13) eine Aufeinanderfolge von mindestens einer Einspeisescheibe (12), mindestens einer Schutzleiterscheibe (11) und mindestens einem Distanzelement (13) beinhalten,
das Gehäuse und die feldbusseitige Funktionsleiterplatte (7) lösbar miteinander verbunden sind,
bei entfernter, weiterhin mit dem Feldbus verbundener feldbusseitiger Funktionsleiterplatte (7) eine lösbare Verbindung zwischen ihr und einer mit dem lokalen Busleiter verbundenen busleiterseitigen Funktionsleiterplatte (10) unterbrochen ist.

2. Feldbusanschlußmodul nach Anspruch 1, **dadurch gekennzeichnet, daß** die Anschlußscheiben (11 - 13) in der Reihenfolge: mindestens eine Einspeisescheibe (12), daran anschließend mindestens ein Distanzelement (13) und als Abschluß mindestens eine Schutzleiterscheibe (11) angeordnet sind.

3. Feldbusanschlußmodul nach einem der Ansprüche 1 oder 2, **dadurch gekennzeichnet, daß** in einem Anschlußblock zwischen mindestens zwei Distanzelementen (13) weitere Einspeisescheiben (12) und/oder Schutzleiterscheiben (11) anordnenbar sind.

4. Feldbusanschlußmodul nach einem der Ansprüch 1 bis 3, **dadurch gekennzeichnet, daß** jedes Distanzelement (13) aus einer Anzahl von Distanzscheiben besteht.

5. Feldbusanschlußmodul nach Anspruch 4, **dadurch gekennzeichnet, daß** jedes Distanzelement (13) vorzugsweise das Reihungsmaß der Anschlußscheiben (11 bis 13) aufweist.

6. Feldbusanschlußmodul nach Anspruch 1, **dadurch gekennzeichnet, daß** die Funktionsleiterplatte (7) auf der dem Gehäuse abgewandten Seite durch einen Deckel (4) übergriffen ist, an dem die Funktionsleiterplatte (7) lösbar befestigbar ist,

7. Feldbusanschlußmodul nach Anspruch 1, **dadurch gekennzeichnet, daß** der Deckel (4) des Gehäuses und/oder die Funktionsleiterplatte (7) um einen Drehpunkt (24) schwenkbar sowie lösbar und verrastbar am Gehäuse befestigt sind.

8. Feldbusanschlußmodul nach einem der Ansprüche 1 und 7, **dadurch gekennzeichnet, daß** die entfernbare Funktionsleiterplatte (7) mindestens einen Steckverbinder aufweist.

9. Feldbusanschlußmodul nach Anspruch 8, **dadurch gekennzeichnet, daß** die entfernbare Funktionsleiterplatte (7) mit dem Gehäusedeckel (4) entfernbar ist.

10. Feldbusanschlußmodul nach einem der Ansprüche 8 oder 9, **dadurch gekennzeichnet, daß** der Steckverbinder ein genormter Feldbusstecker (5) ist.

11. Feldbusanschlußmodul nach einem der vorstehenden Ansprüche, **dadurch gekennzeichnet, daß** die entfernbare Funktionsleiterplatte (7) mindestens einen Verbinder (6) zur Direktverdrahtung der Feldbuskabel mit dem Feldbusanschlußmodul aufweist.

12. Feldbusanschlußmodul nach einem der Ansprüche 1, 8 oder 11, **dadurch gekennzeichnet, daß** Steckverbinder (5) und Verbinder (6) zur Direktverdrahtung miteinander elektrisch verbunden sind.

13. Feldbusanschlußmodul nach einem der vorhergehenden Ansprüche, **dadurch gekennzeichnet, daß** der Deckel (4) des Gehäuses ohne die Funktionsleiterplatte (7) entfernbar ist und die Funktionsleiterplatte (7) bei entferntem Deckel (4) weiterhin die Verbindung zwischen lokalem Busleiter und Feldbus herstellt.

14. Feldbusanschlußmodul nach einem der vorhergehenden Ansprüche, **dadurch gekennzeichnet, daß** der Deckel (4) Ausnehmungen (15) zum Durchtreten der Feldbusanschlußkabel und -stecker aufweist.

15. Feldbusanschlußmodul nach Anspruch 1, **dadurch gekennzeichnet, daß** die Ankopplung von Feldbus und lokalem Busleiter über mindestens zwei funktionell getrennte, lösbar miteinander elektrisch und mechanisch verbindbare Funktionsleiterplatten (7, 10) herstellbar ist.

16. Feldbusanschlußmodul nach einem der Ansprüche 1 und 15, **dadurch gekennzeichnet, daß** die feldbusseitig angeordnete Funktionsleiterplatte (7) alle Verbindungselemente (5, 6) zum Feldbus beinhaltet.

17. Feldbusanschlußmodul nach einem der Ansprüche 1, 15 und 16, **dadurch gekennzeichnet, daß** die busleiterseitig angeordnete Funktionsleiterplatte (10) alle Funktionen zur Signalanpassung beinhaltet.

18. Feldbusanschlußmodul nach einem der vorhergehenden Ansprüche, **dadurch gekennzeichnet, daß** die feldbusseitige Funktionsleiterplatte (7) am Gehäusedeckel (4) befestigbar ist und nach Entfernen des Deckels (4) die lösbare Verbindung der Funktionsleiterplatten (7, 10) untereinander zwangsläufig aufgehoben ist.

19. Feldbusanschlußmodul nach einem der vorhergehenden Ansprüche, **dadurch gekennzeichnet, daß** die Funktionsleiterplatten (7, 10) in den Feldbusanschlußmodul mit der Platten-ebene parallel zum Gehäuseboden einsteckbar sind.

20. Feldbusanschlußmodul nach einem der Ansprüche 1 und 17, **dadurch gekennzeichnet, daß** die busleiterseitige Funktionsleiterplatte (10) fest in das Gehäuse des Feldbusanschlußmoduls eingesteckt und zur Potentialverteilung für den Busleiter elektrisch mit einer Einspeisescheibe (12) verbunden ist.

21. Feldbusanschlußmodul nach einem der vorhergehenden Ansprüche, **dadurch gekennzeichnet, daß** ein Abgriff elektrischer Potentiale für dem Feldbusmodul zugeordnete Anschlußblocks durch Querverteilung an einsteckbaren Anschlußelementen (17) in mindestens einer Vorrichtung (14) zur Aufnahme von Verteilerleisten (32) erfolgt.

22. Feldbusanschlußmodul nach Anspruch 1, **dadurch gekennzeichnet, daß** eine Einspeisescheibe (12) mindestens zwei Vorrichtungen (14) zur Aufnahme von Verteilerleisten (32) und eine mechanische Rastfußfunktion (9) aufweist.

23. Feldbusanschlußmodul nach Anspruch 1 und 22, **dadurch gekennzeichnet, daß** eine Schutzleiterscheibe (11) eine mechanische Rastfußfunktion (9) aufweist und einen elektrischen Kontakt (31) des Busleiters zur Tragschiene (1) herstellt.

24. Feldbusanschlußmodul nach Anspruch 1, 4, 22 und 23, **dadurch gekennzeichnet, daß** durch Zwischenreihung von Distanzscheiben zu Distanzelementen (13) unterschiedliche Baulängen des Feldbusanschlußmoduls zur Aufnahme unterschiedlich langer Funktionsleiterplatten (7, 10) herstellbar ist.

25. Feldbusanschlußmodul nach einem der vorhergehenden Ansprüche, **dadurch gekennzeichnet, daß** die Distanzscheiben einen Anschlagfuß (29) zur mechanischen Positionierung ohne Rastfunktion (9) aufweisen.

## Claims

1. A field bus connection module for coupling a local bus conductor to an associated field bus system including
at least one function circuit board (7) for matching the signals of a local bus conductor to the field bus system,
connecting elements (5, 6) for making a releasable electrical connection between the field bus and the field bus connection module, and
a connection (10) of the field bus connection module to the local bus conductor,
characterised in that
the underside and side walls of a housing of the field bus connection module are formed from a number of connection plates (11-13) which can be arranged together in a row,
the connection plates (11-13) include a series of at least one feed-in plate (12), at least one protective conductor plate (11) and at least one spacer element (13),
the housing and the field bus-side function circuit board (7) are releasably connected together and
when the field bus-side function circuit board (7) is removed but still connected to the field bus a releasable connection between the field bus-side function circuit board and a bus conductor-side function circuit board (10) connected to the local bus conductor is interrupted.

2. A field bus connection module according to claim 1 characterised in that the connection plates (11-13) are arranged in the sequence: at least one feed-in plate (12), then at least one spacer element (13) and finally at least one protective conductor plate (11).

3. A field bus connection module according to one of claims 1 and 2 characterised in that further feed-in plates (12) and/or protective conductor plates (11) can be arranged in a connection block between at least two spacer elements (13).

4. A field bus connection module according to one of claims 1 to 3 characterised in that each spacer element (13) comprises a number of spacer plates.

5. A field bus connection module according to claim 4 characterised in that each spacer element (13) is preferably of the row-wise dimension of the connection plates (11 to 13).

6. A field bus connection module according to claim 1 characterised in that on the side remote from the housing a cover (4) is fitted over the function circuit board (7), to which cover the function circuit board (7) can be releasably fixed.

7. A field bus connection module according to claim 1 characterised in that the cover (4) of the housing and/or the function circuit board (7) are fixed to the housing pivotably about a pivot point (24) and releasably and latchably.

8. A field bus connection module according to one of claims 1 and 7 characterised in that the removable function circuit board (7) has at least one plug connector.

9. A field bus connection module according to claim 8 characterised in that the removable function circuit board (7) is removable with the housing cover (4).

10. A field bus connection module according to one of claims 8 and 9 characterised in that the plug connector is a standardised field bus plug (5).

11. A field bus connection module according to one of the preceding claims characterised in that the removable function circuit board (7) has at least one connector (6) for direct wiring of the field bus cables to the field bus connection module.

12. A field bus connection module according to one of claims 1, 8 and 11 characterised in that the plug connector (5) and the connector (6) are electrically connected together for direct wiring.

13. A field bus connection module according to one of the preceding claims characterised in that the cover (4) of the housing is removable without the function circuit board (7) and with the cover (4) removed the function circuit board (7) still provides the connection between the local bus conductor and the field bus.

14. A field bus connection module according to one of the preceding claims characterised in that the cover (4) has openings (15) for the field bus connection cables and plugs to pass therethrough.

15. A field bus connection module according to claim 1 characterised in that the coupling of the field bus and the local bus conductor can be made by way of at least two functionally separate function circuit boards (7, 10) which can be releasably electrically and mechanically connected together.

16. A field bus connection module according to one of claims 1 and 15 characterised in that the function circuit board (7) arranged on the field bus side includes all connecting elements (5, 6) to the field bus.

17. A field bus connection module according to one of claims 1, 15 and 16 characterised in that the function circuit board (10) arranged on the bus conductor side contains all functions for signal matching.

18. A field bus connection module according to one of the preceding claims characterised in that the field bus-side function circuit board (7) can be fixed to the housing cover (4) and after removal of the cover (4) the releasable connection of the function circuit boards (7, 10) to each other is necessarily interrupted.

19. A field bus connection module according to one of the preceding claims characterised in that the function circuit boards (7, 10) can be inserted into the field bus connection module with the board plane in parallel relationship to the bottom of the housing.

20. A field bus connection module according to one of claims 1 and 17 characterised in that the bus conductor-side function circuit board (10) is fixedly inserted into the housing of the field bus connection module and for potential distribution for the bus conductor is electrically connected to a feed-in plate (12).

21. A field bus connection module according to one of the preceding claims characterised in that a tapping of electrical potentials for connection blocks associated with the field bus module is effected by cross-distribution at plug-in connection elements (17) in at least one device (14) for receiving distributor bars (32).

22. A field bus connection module according to claim 1 characterised in that a feed-in plate (12) has at least two devices (16) for receiving distributor bars (32) and a mechanical retaining foot function (9).

23. A field bus connection module according to claims 1 and 22 characterised in that a protective conductor plate (11) has a mechanical retaining foot function (9) and makes an electrical contact (31) of the bus conductor with the mounting rail (1).

24. A field bus connection module according to claims 1, 4, 22 and 23 characterised in that different structural lengths of the field bus connection module for receiving function circuit boards (7, 10) of different lengths can be produced by intermediate positioning of spacer plates in a row to form spacer elements (13).

25. A field bus connection module according to one of the preceding claims characterised in that the spacer plates have an abutment foot (29) for mechanical positioning without a retaining function (9).

## Revendications

1. Module de raccordement de bus de secteur pour le couplage d'un conducteur de bus local à un système de bus de secteur associé contenant
au moins une plaquette de circuits imprimés de fonction (7) pour l'adaptation des signaux d'un conducteur de bus local au système de bus de secteur,
des éléments de liaison (5, 6) réalisant une liaison électrique démontable entre le bus de secteur et le module de raccordement de bus de secteur,
une liaison (10) entre le module de raccordement de bus de secteur et le conducteur de bus local,
**caractérisé en ce que**
la face inférieure et les parois latérales d'un boîtier d'un module de raccordement de bus de secteur sont formées par un certain nombre de disques de raccordement (11 à 13) pouvant être disposés en rangées juxtaposées,
les disques de raccordement (11 à 13) contiennent une succession d'au moins un disque d'alimentation (12), d'au moins un disque de conducteur de protection (11) et d'au moins un élément d'écartement (13),
le boîtier et la plaquette de circuits imprimés de fonction côté bus de secteur sont assemblés entre eux de manière amovible,
lorsque la plaquette de circuits imprimés de fonction (7) côté bus de secteur est enlevée, en étant toujours reliée au bus de secteur, une liaison démontable entre celle-ci et une plaquette de circuits imprimés de fonction (10) côté conducteur de bus, reliée au conducteur de bus local, est interrompue.

2. Module de raccordement de bus de secteur selon la revendication 1, caractérisé en ce que les disques de raccordement (11 a 13) sont disposés dans cet ordre: au moins un disque d'alimentation (12), au moins un élément d'écartement (13) s'y raccordant et enfin, au moins un disque de conducteur de protection (11).

3. Module de raccordement de bus de secteur selon l'une des revendications 1 ou 2, caractérisé en ce que dans un bloc de raccordement on peut disposer, entre au moins deux éléments d'écartement (13), d'autres disques d'alimentation (12) et/ou disques de conducteur de protection (11).

4. Module de raccordement de bus de secteur selon l'une des revendications 1 à 3, caractérisé en ce que chaque élément d'écartement (13) est constitué d'un certain nombre de disques d'écartement.

5. Module de raccordement de bus de secteur selon la revendication 4, caractérisé en ce que chaque élément d'écartement (13) présente de préférence la mesure de mise en série des disques de raccordement (11 à 13).

6. Module de raccordement de bus de secteur selon la revendication 1, caractérisé en ce que sur la plaquette de circuits imprimés de fonction (7) passe, sur le côté tourné à l'opposé du boîtier, un couvercle (4), sur lequel la plaquette de circuits imprimés de fonction (7) peut être fixée de manière démontable.

7. Module de raccordement de bus de secteur selon la revendication 1, caractérisé en ce que le couvercle (4) du boîtier et/ou la plaquette de circuits imprimés de fonction (7) sont fixés sur le boîtier de manière à pouvoir pivoter autour d'un point de rotation (24), ainsi que de manière démontable et accrochable.

8. Module de raccordement de bus de secteur selon l'une des revendications 1 et 7, caractérisé en ce que la plaquette de circuits imprimés de fonction (7) pouvant être enlevée comporte au moins un connecteur à fiches.

9. Module de raccordement de bus de secteur selon la revendication 8, caractérisé en ce que la plaquette de circuits imprimés de fonction (7) pouvant être enlevée peut être enlevée avec le couvercle (4) du boîtier.

10. Module de raccordement de bus de secteur selon l'une des revendications 8 ou 9, caractérisé en ce que le connecteur à fiches est un connecteur de bus de secteur (5) normalisé.

11. Module de raccordement de bus de secteur selon l'une des revendications précédentes, caractérisé en ce que la plaquette de circuits imprimés de fonction (7) pouvant être enlevée comporte au moins un connecteur (6) pour le câblage direct du câble de bus de secteur avec le module de raccordement de bus de secteur.

12. Module de raccordement de bus de secteur selon l'une des revendications 1, 8 ou 11, caractérisé en ce que le connecteur à fiches (5) et le connecteur (6) sont reliés électriquement entre eux pour le câblage direct.

13. Module de raccordement de bus de secteur selon l'une des revendications précédentes, caractérisé en ce que le couvercle (4) du boîtier peut être enlevé sans la plaquette de circuits imprimés de fonction (7) et la plaquette de circuits imprimés de fonction (7) continue de réaliser la liaison entre le conducteur de bus local et le bus de secteur, lorsque le couvercle (4) est enlevé.

14. Module de raccordement de bus de secteur selon l'une des revendications précédentes, caractérisé en ce que le couvercle (4) présente des évidements (15) pour le passage de câbles et de connecteurs de raccordement de bus de secteur.

15. Module de raccordement de bus de secteur selon la revendication 1, caractérisé en ce que l'accouplement du bus de secteur et du conducteur de bus local peut être réalisé par l'intermédiaire d'au moins deux plaquettes de circuits imprimés de fonction (7, 10) fonctionnellement séparées, pouvant être reliées entre elles électriquement et mécaniquement de manière démontable.

16. Module de raccordement de bus de secteur selon l'une des revendications 1 et 15, caractérisé en ce que la plaquette de circuits imprimés de fonction (7), disposée côté bus de secteur, contient tous les éléments de liaison (5, 6) avec le bus de secteur.

17. Module de raccordement de bus de secteur selon l'une des revendications 1, 15 et 16, caractérisé en ce que la plaquette de circuits imprimés de fonction (10), disposée côté conducteur de bus, contient toutes les fonctions pour l'adaptation des signaux.

18. Module de raccordement de bus de secteur selon l'une des revendications précédentes, caractérisé en ce que la plaquette de circuits imprimés de fonction (7) côté bus de secteur peut être fixée sur le couvercle (4) du boîtier et, après enlèvement du couvercle (4), la liaison démontable des plaquettes de circuits imprimés de fonction (7, 10) entre elles est forcément supprimée.

19. Module de raccordement de bus de secteur selon l'une des revendications précédentes, caractérisé en ce que les plaquettes de circuits imprimés de fonction (7, 10) peuvent être enfichées dans le module de raccordement de bus de secteur avec le plan des plaquettes parallèle au fond du boîtier.

20. Module de raccordement de bus de secteur selon l'une des revendications 1 et 17, caractérisé en ce que la plaquette de circuits imprimés de fonction (10) côté conducteur de bus est enfichée fixement dans le boîtier du module de raccordement de bus de secteur et est électriquement reliée à un disque d'alimentation (12), en vue de la distribution du potentiel pour le conducteur de bus.

21. Module de raccordement de bus de secteur selon l'une des revendications précédentes, caractérisé en ce qu'il est procédé au prélèvement de potentiels électriques pour des blocs de raccordement, associés au module de bus de secteur, par distribution transversale à des éléments de raccordement (17) enfichables, dans au moins un dispositif (14) destiné à recevoir des barres de distribution (32).

22. Module de raccordement de bus de secteur selon la revendication 1, caractérisé en ce qu'un disque d'alimentation (12) comporte au moins deux dispositifs (14) destinés à recevoir des barres de distribution (32) et présente une fonction de pied d'encliquetage mécanique (9).

23. Module de raccordement de bus de secteur selon l'une des revendications 1 et 22, caractérisé en ce qu'un disque de conducteur de protection (11) présente une fonction de pied d'encliquetage mécanique (9) et réalise un contact électrique (31) entre le conducteur de bus et le rail de support.

24. Module de raccordement de bus de secteur selon l'une des revendications 1, 4, 22 et 23, caractérisé en ce qu'en intercalant des disques d'écartement et des éléments d'écartement (13) il est possible de réaliser des longueurs de construction différentes du module de raccordement de bus de secteur, pour recevoir des plaquettes de circuits imprimés de fonction (7, 10) de longueurs différentes.

25. Module de raccordement de bus de secteur selon l'une des revendications précédentes, caractérisé en ce que les disques d'écartement présentent un pied de butée (29) pour le positionnement mécanique sans fonction d'encliquetage (9).
